**Europäisches Patentamt**

**European Patent Office**

**Office européen des brevets**

(19)

(11) Veröffentlichungsnummer: **0 164 504**
**B1**

(12) **EUROPÄISCHE PATENTSCHRIFT**

(45) Veröffentlichungstag der Patentschrift:
02.08.89

(51) Int. Cl.⁴: **G 01 S 7/40,** G 01 R 29/10

(21) Anmeldenummer: **85102991.8**

(22) Anmeldetag: **15.03.85**

(54) **Antennenanordnung für ein Radarprüfgerät.**

(30) Priorität: **14.05.84 CH 2365/84**

(43) Veröffentlichungstag der Anmeldung:
**18.12.85 Patentblatt 85/51**

(45) Bekanntmachung des Hinweises auf die Patenterteilung:
**02.08.89 Patentblatt 89/31**

(84) Benannte Vertragsstaaten:
**BE CH DE GB IT LI NL SE**

(56) Entgegenhaltungen:
**CH-A-545 482**

**Q.S.T. AMATEUR RADIO, Band 58, Nr. 11,
November 1974, Seiten 35-41, Newington, US; D.
TURRIN: "Antenna performance measurements"
1975 IEEE INTERCON CONFERENCE RECORD,
Technical papers presented at the 1975
International Convention and Exposition of the
IEEE, 8.-10. April 1975, New York, Band 1, Seiten 1-7,
IEEE, New York, US; R.T. KNADLE, Jr.: "UHF
antenna ratiometry: an outdoor range
improvement technique"
ELECTRO/83 CONFERENCE RECORD, 18.-20. April
1983, New York, Seiten 1-13, Electronic
Conventions, Inc., US; E.L. BRONAUGH: "Opensite verification of EMC antenna factors"**

(73) Patentinhaber: **SIEMENS- ALBIS
AKTIENGESELLSCHAFT, EGA1/Verträge und
Patente Postfach, CH- 8047 Zürich (CH)**

(72) Erfinder: **Küpfer, Hanspeter, Stöckenstrasse 46,
CH- 8903 Birmensdorf (CH)**

## Beschreibung

Die Erfindung betrifft eine Antennenanordnung für ein Radarprüfgerät mit einem Strahler, der zumindest angenähert gegen die hinsichtlich ihrer Peilachse zu prüfende und/oder zu justierende Antenne des zu prüfenden Radargerätes orientierbar ist und zur Simulation eines von einem virtuellen Strahlungszentrum ausgehenden Zielsignals ein Prüfsignal als Wellenfront abstrahlt.

Aus der schweizerischen Patentschrift CH-A-545 482 ist ein Radarprüfgerät bekannt, dessen Antennenanordnung relativ hoch an einem Mast fixiert werden muß, um beim Prüfen die Ungenauigkeiten zu vermeiden, die sich aus den Bodenreflexionseffekten ergeben. Dadurch erweisen sich die Vorbereitungsarbeiten für die Prüfung als relativ kompliziert und aufwendig.

Durch die Zeitschrift Q.S.T. AMATEUR RADIO, Band 58, Nr. 11, November 1974, Seiten 35-41 und durch die Zeitschrift 1975 IEEE INTERCON CONFERENCE RECORD / New York Band 1, Seiten 1 bis 7 ist es unter anderem bekannt, daß bei einem über dem Boden angeordneten Sender und einem ebenso angeordneten Empfänger die Wellenausbreitung auf zwei Wegen geschieht, was zu Interferenzen führt. Bei den in diesen Literaturstellen beschriebenen Anordnungen ist charakteristisch, daß das sozusagen virtuelle Phasenzentrum, aus dem die Strahlung wegen der Zweiwege-Ausbreitung zu kommen scheint, nicht eindeutig definiert ist. Das wirkt sich vor allem bei der Peilachsenbestimmung oder Justierung von Radarantennen nachteilig aus.

Nach der Erfindung wird dieser Schwierigkeit dadurch begegnet, daß

a) die Antennenanordnung einen tragbaren, ebenen, elektrisch leitenden Reflektor aufweist, an dem ein Träger mit dem eingebauten Strahler zumindest angenähert am Rande und oberhalb der leitenden Ebene desselben befestigt ist,

b) die Abmessungen der Oberfläche des Reflektors so gewählt sind, daß dieser mindestens die halbe erste Fresnelzone im Strahlungsfeld überdeckt,

c) zur Prüfung des Radargerätes der Abstand zwischen dem Phasenzentrum des Strahlers und der leitenden Ebene so gewählt ist, daß sich die direkte Welle und die von der leitenden Ebene des Reflektors reflektierte Welle am Ort der Antenne des zu prüfenden Radargerätes maximal gegenseitig unterstützen und somit der Fußpunkt des Lotes vom Phasenzentrum des Strahlers auf den ebenen Reflektor das virtuelle Strahlungszentrum der Antennenanordnung bildet.

Es ist zwar eine Meß- und Prüfeinrichtung für Antennen bekannt, bei der der Boden durch einen metallischen Reflektor sozusagen ersetzt ist. Dieser metallische Reflektor erstreckt sich aber über die gesamte Fläche zwischen Sender und Empfänger. Die Meßeinrichtung ist im übrigen auch nicht für die Peilachsenbestimmung und/oder Justierung bzw. eine Diagrammmessung bestimmt und geeignet, sondern dient nur der Feststellung des Antennenfaktors worunter das Verhältnis von Antennenfeldstärke zur Ausgangsspannung verstanden wird. Beschrieben ist diese Einrichtung in ELECTRO/83 CONFERENCE RECORD, 18.-20. April 1983, New York, Seiten 1-13.

Nachfolgend wird die Erfindung anhand von Zeichnungen, die Ausführungsbeispiele zeigen, näher erläutert. Dabei zeigt:

Fig. 1 eine schematische Darstellung der Bodenreflexionseffekte mit einer Antennenanordnung nach dem Stand der Technik und nach der vorliegenden Erfindung.

Fig. 2 den Grund- und Aufriß einer erfindungsgemäßen Antennenanordnung

Fig. 3 eine Skizze zur Berechnung der maßgebenden Parameter in einer Antennenanordnung nach der Erfindung

Fig. 4 eine schematische Darstellung des Strahlungsdiagramms einer solchen Antennenanordnung.

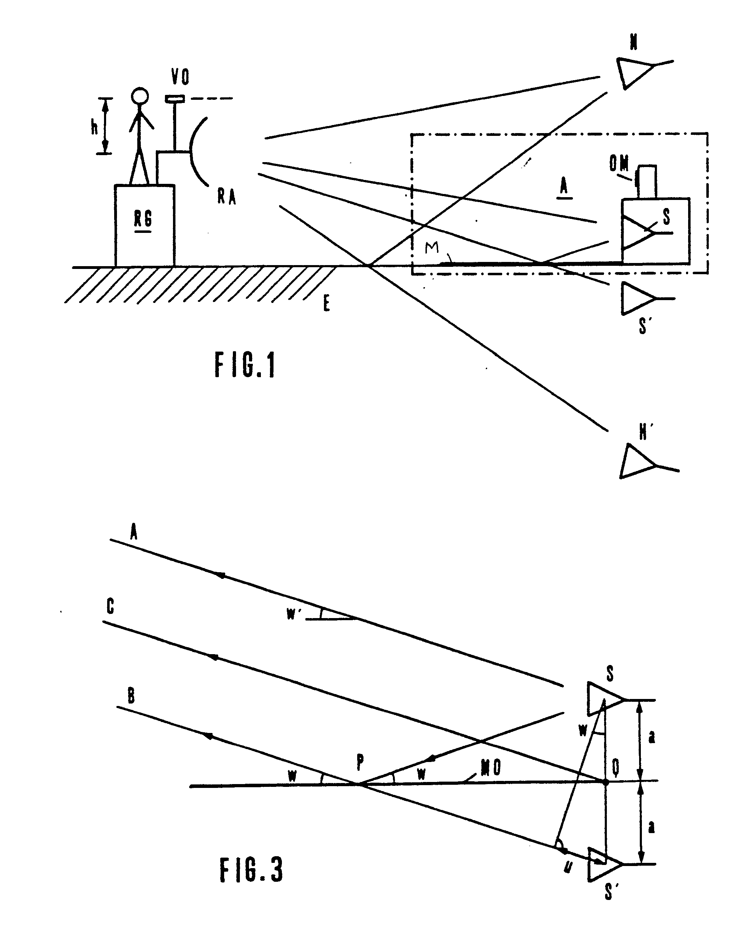

In Fig. 1 ist ein mobiles Radargerät RG mit einer schwenkbaren Radarantenne RA schematisch dargestellt, deren Peilachse zwecks Richtungsjustierung in Richtung auf einen gemäß dem Stand der Technik an einem Mast fixierten Strahler H oder auf eine erfindungsgemäße einen Strahler S aufweisende Antennenanordnung A orientiert werden kann, die auf dem Boden E liegt, wobei zur Vereinfachung der Figur der Mast nicht dargestellt ist. Gegebenenfalls kann die Antennenanordnung mit einer Visiermarke OM in einem Abstand h vom virtuellen Strahlungszentrum der Antennenanordnung und die Radarantenne RA mit einer Visieroptik VO im selben Abstand h zur Peilachse der Radarantenne RA versehen sein, um zwecks Parallaxe-Ausgleichs diese Peilachse möglichst genau parallel in einem Abstand h zur optischen Achse einstellbar zu machen. In Fig. 1 sind zudem die gegenüber der Bodenlinie gespiegelten virtuellen Strahler H' bzw. S' dargestellt.

Eine vom Strahler H direkt abgestrahlte oder empfangene Welle interferiert mit der gespiegelten, so dass die Radarantenne RA sich nicht nach einer Wellenfront in Richtung des Strahlers H, sondern nach einer solchen in Richtung der maximal empfangenen Energie orientiert. Somit wird vom Radargerät eine verfälschte Richtung bestimmt und die Justierung und Kontrolle der Peilachse der Radarantenne erschwert oder verunmöglicht. Nach dem Stand der Technik wird dem Abhilfe geleistet, indem man den Strahler H, relativ hoch an einem Mast fixiert; dann ist die reflektierte Welle genügend schwach, und zwar infolge der Bündelung beider beteiligten Antennen.

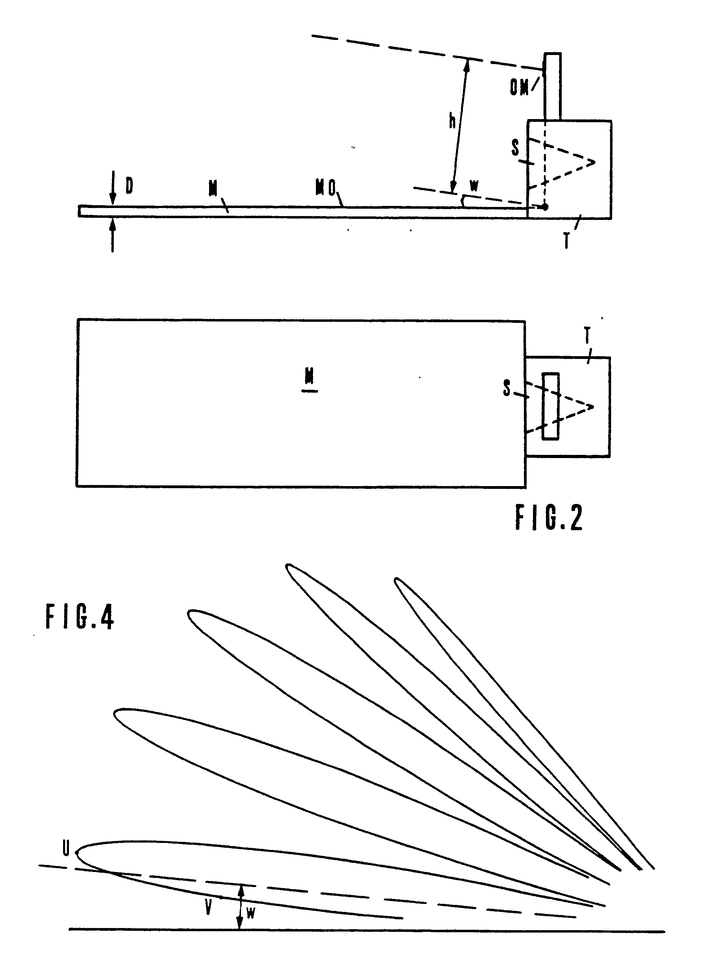

Die in Fig. 2 dargestellte Antennenanordnung weist einen tragbaren ebenen Reflektor M auf, an dem ein zum Zweck des Transports abnehmbarer Träger T mit eingebautem Strahler S befestigt ist. Der Träger T ist mit einer optischen Marke OM versehen. Der ebene Reflektor M muss mindestens die halbe erste Fresnelzone im Strahlungsfeld abdecken und muss deshalb in der Längsrichtung grösser als in der Breite sein. Als Reflektor kann beispielsweise ein Blech oder eine Platte aus Aluminium dienen. In Fig. 2 ist vorzugsweise eine Antennenanordnung mit einem dünnen rechteckförmigen Metallreflektor dargestellt. Um Gewicht zu sparen, könnte der Reflektor beispielsweise zum Teil elliptisch ausgebildet sein. Ebenfalls könnte eine Ausführung als Sandwich-Konstruktion Vorteile bieten, um den Reflektor sowohl robust als auch möglichst dünn auszubilden.

In Fig. 3 ist eine schematische Darstellung des Strahlers S und der Oberfläche MO des Reflektors M nach Fig. 2 sowie des gespiegelten Strahlers S′ angegeben, wobei der Abstand zwischen den Phasenzentren der Strahler S und S′ den Wert 2a aufweist. Eine vom Strahler S abgestrahlte Welle geht in Richtung A, die einen Winkel w′ mit der Oberfläche MO bildet, zur nichtdargestellten Radarantenne RA (Fig. 1). Eine weitere vom Strahler S abgestrahlte Wellen reflektiert im Punkt P auf der Oberfläche des Reflektors und geht in Richtung B, die einen Winkel w mit der Oberfläche MO bildet, ebenfalls zur Radarantenne RA.

Da die Entfernung der Antennenanordnung A zur Radarantenne, z. B. in der Grössenordnung von 40 bis 100 m, viel grösser als der Abstand 2a ist, sind die Winkel w′ und w praktisch gleich. Die reflektierte Welle erfährt im Punkt P eine Phasendrehung von etwa 180°. Wenn daher L die Wellenlänge und u der Wegunterschied zwischen der direkten und der reflektierten Wellen ist, ergibt sich eine Interferenzverstärkung wenn $u = nL + L/2$ ist. Dann entsteht ein Abstrahl-Maximum in Richtung C zur Radarantenne, wobei die Gerade C in der Mitte zwischen den Geraden A und B liegt. Von der Radarantenne aus gesehen scheint die Überlagerung der Welle der Strahler S und S′ (Fig. 3) dem Punkt Q als neuem Phasenzentrum zu entspringen. Der Punkt Q ist somit das Phasenzentrum bzw. virtuelle Strahlungszentrum der Antennenanordnung und die bei der Radarantenne entstehende Wellenfront scheint dem Punkt Q zu entspringen. Die Kontrolle und Justierung der Radarantenne wird daher in bezug auf diesen Punkt vorgenommen, der somit ein künstlich erzeugtes Ziel darstellt.

Für den Wegunterschied u gilt gemäss Fig. 3

$$u = 2\,a\,\sin w$$

Daraus ergibt sich

$$a = (L/2)(n + 1/2)/\sin w$$

worin n die Werte 0, 1, 2, ... annehmen kann, die den verschiedenen Strahlungskeulen gemäss Fig. 4 entsprechen. Für den Wert n = 0 gilt

$$a_o = L/4 \sin w$$

In der Praxis kann a derart gewählt werden, dass für n = 0

$$L/8 \sin w < a < 3\,L/8 \sin w$$

ist; vorzugsweise sollen jedoch die grösseren Werte von a gewählt werden. Die Richtung w zur Radarantenne fällt dann in den unteren Bereich U...V der untersten Strahlungskeule der Antennenanordnung gemäss Fig. 4. Damit wird eine besonders gute Unterdrückung der Wirkung von evtl. verblendenden Bodenreflexionsanteilen bewirkt. Vorzugsweise soll der Reflektor so dünn ausgebildet sein, dass bei einer Aufstellung am Boden seine leitende Oberfläche praktisch die Boden-Oberfläche fortsetzt.

## Patentansprüche

1. Antennenanordnung (A) für ein Radarprüfgerät mit einem Strahler (S), der zumindest angenähert gegen die hinsichtlich ihrer Peilachse zu prüfende und/oder zu justierende Antenne (RA) des zu prüfenden Radargerätes (RG) orientierbar ist und zur Simulation eines von einem virtuellen Strahlungszentrum ausgehenden Zielsignals ein Prüfsignal als Wellenfront abstrahlt, gekennzeichnet durch folgende Merkmale:

a) die Antennenanordnung weist einen tragbaren, ebenen, elektrisch leitenden Reflektor (M) auf, an dem ein Träger (T) mit dem eingebauten Strahler (S) zumindest angenähert am Rande und oberhalb der leitenden Ebene (MO) desselben befestigt ist,

b) die Abmessungen der Oberfläche des Reflektors (M) sind so gewählt, daß dieser die halbe erste Fresnelzone im Strahlungsfeld überdeckt,

c) zur Prüfung des Radargerätes ist der Abstand a zwischen dem Phasenzentrum des Strahlers (S) und der leitenden Ebene (MO) so gewählt, daß sich die direkte Welle und die von der leitenden Ebene (MO) des Reflektors (M) reflektierte Welle am Ort der Antenne (RA) des zu prüfenden Radargerätes (RG) maximal gegenseitig unterstützen und somit der Fußpunkt (Q) des Lotes vom Phasenzentrum des Strahlers (S) auf den ebenen Reflektor (M) das virtuelle Strahlungszentrum der Antennenanordnung (A) bildet.

2. Antennenanordnung nach Anspruch 1, dadurch gekennzeichnet, daß für den Abstand a zwischen dem Phasenzentrum des Strahlers (S) und der leitenden Ebene (MO) die Beziehung

$$\frac{L}{8\sin w} < a < \frac{3L}{8\sin w}$$

gilt, worin L die Wellenlänge und w der Winkel ist, der die Richtung zum Radargerät gegenüber der leitenden Ebene (MO) darstellt.

3. Antennenanordnung nach Anspruch 1 oder 2, <u>dadurch gekennzeichnet</u>, daß die Dicke (D) des Reflektors (M) kleiner als die Wellenlänge L ist.

## Claims

1. Antenna arrangement (A) for a radar test apparatus with a radiator (S), which is able to be oriented at least approximately against the antenna (RA) of the radar apparatus (RG) to be examined, the directional axis of which is to be examined and/or adjusted, and for simulating a target signal emanating from a virtual radiation centre, emits a test signal as wave front, characterised by the following features:

a) the antenna arrangement has a portable, planar, electrically conductive reflector (M) on which a carrier (T) with the mounted radiator (S) is secured at least approximately on the edge and above the conducting plane (MO) of the same,

b) the dimensions of the surface of the reflector (M) are selected in such a way that this covers half of the first Fresnel zone in the radiation field,

c) for examining the radar apparatus the distance a between the phase centre of the radiator (S) and the conducting plane (MO) is selected such that the direct wave and the wave reflected by the conducting plane (MO) of the reflector (M) support each other maximally at the location of the antenna (RA) of the radar apparatus (RG) to be examined and thus the base point (Q) of the vertical line from the phase centre of the radiator (S) onto the plane reflector (M) forms the virtual radiation centre of the antenna arrangement (A).

2. Antenna arrangement according to claim 1, characterised in that for the distance a between the phase centre of the radiator (S) and the conducting plane (MO) the following equation applies:

$$\frac{L}{8\sin w} < a < \frac{3L}{8\sin w}$$

in which L is the wavelength and w the angle, which represents the direction to the radar apparatus compared to the conducting plane (MO).

3. Antenna arrangement according to claim 1 or 2, characterised in that the thickness (D) of the reflector (M) is smaller than the wavelength L.

## Revendications

1. Dispositif d'antenne (A) pour un appareil d'essai d'un radar, comportant un élément rayonnant (S), qui peut être orienté au moins approximativement en direction de l'antenne (RA), dont l'axe d'orientation doit être contrôlé et/ou ajusté, de l'appareil radar (RG) à contrôler et émet un signal de contrôle sous la forme d'un front d'onde, en vue de simuler un signal de cible partant d'un centre virtuel de rayonnement, remarquable par les caractéristiques suivantes:

a) le dispositif d'antenne comporte un réflecteur portable plat (M), électriquement conducteur, sur lequel un support (T), sur lequel est monté l'élément rayonnant (S), est fixé au moins approximativement au niveau du bord et au-dessus du plan conducteur (MO) du réflecteur,

b) les dimensions de la surface du réflecteur (M) sont choisies de manière que ce dernier recouvre la moitié de la première zone de Fresnel dans le champ de rayonnement,

c) pour le contrôle de l'appareil radar, la distance a entre le centre de phase de l'élément rayonnant (S) et le plan conducteur (MO) est choisie de telle sorte que l'onde directe et l'onde réfléchie par le plan conducteur (MO) du réflecteur (M) se renforcent réciproquement d'une manière maximale à l'emplacement de l'antenne (RA) de l'appareil radar (RG) à contrôler, et par conséquent le pied (Q) de la perpendiculaire abaissée depuis le centre de phase de l'élément rayonnant (S) sur le réflecteur plan (M) forme le centre virtuel de rayonnement du dispositif d'antenne (A).

2. Dispositif d'antenne suivant la revendication 1, caractérisé par le fait que pour la distance a entre le centre de phase de l'élément rayonnant (S) et le plan conducteur (MO), on a la relation

$$\frac{L}{8\sin w} < a < \frac{3L}{8\sin w},$$

L désignant la longueur d'onde et w l'angle, que fait la direction, dans laquelle se situe l'appareil radar, par rapport au plan conducteur (MO).

3. Dispositif d'antenne suivant la revendication 1 ou 2, caractérisé par le fait que l'épaisseur (D) du réflecteur (M) est inférieure à la longueur d'onde L.

FIG.1

FIG.3

FIG.2

FIG.4